(19) **Europäisches Patentamt / European Patent Office / Office européen des brevets**

(11) **EP 4 773 329 A1**

(12) **EUROPEAN PATENT APPLICATION**
published in accordance with Art. 153(4) EPC

(43) Date of publication:
08.07.2026 Bulletin 2026/28

(21) Application number: 24953585.7

(22) Date of filing: 21.11.2024

(51) International Patent Classification (IPC):
$H01M\ 10/42^{(2006.01)}$      $G01R\ 31/36^{(2020.01)}$

(52) Cooperative Patent Classification (CPC):
Y02E 60/10

(86) International application number:
PCT/CN2024/133385

(87) International publication number:
WO 2026/051209 (12.03.2026 Gazette 2026/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 05.09.2024 CN 202411248353

(71) Applicant: Eve Energy Co., Ltd.
Huizhou, Guangdong 516006 (CN)

(72) Inventors:
• WANG, Xiaobin
Huizhou, Guangdong 516006 (CN)

• DING, Xunfeng
Huizhou, Guangdong 516006 (CN)
• ZHOU, Hongquan
Huizhou, Guangdong 516006 (CN)
• ZHONG, Yu
Huizhou, Guangdong 516006 (CN)
• XU, Yuhong
Huizhou, Guangdong 516006 (CN)
• JIANG, Jibing
Huizhou, Guangdong 516006 (CN)

(74) Representative: Zhu, Puxing
Mars Universe IP
c/o Spaces
Mühldorfstraße 8
81671 München (DE)

(54) **BATTERY THERMAL RUNAWAY EARLY-WARNING METHOD AND APPARATUS, ELECTRONIC DEVICE, AND STORAGE MEDIUM**

(57) The present application provides a battery thermal runaway warning method and apparatus, an electronic device and a storage medium. With the method, electrical performance data sequences of a battery to be detected are obtained, filtering and detection processing is performed on the electrical performance data sequences to obtain filtered electrical performance data, it is determined whether the battery meets a preset alarm condition based on the filtered electrical performance data, and a warning signal is output when the battery meets the preset alarm condition, thereby improving the accuracy and effectiveness of the warning of thermal runaway of the battery.

obtaining electrical performance data sequences comprising a plurality of respective sequences of a plurality of types of electrical performance data of a battery to be detected — 101

↓

performing filtering and detection processing on the electrical performance data sequences to obtain filtered electrical performance data — 102

↓

determining, based on the filtered electrical performance data, whether the battery meets a preset alarm condition, and outputting a warning signal when the battery meets the preset alarm condition — 103

FIG. 1

EP 4 773 329 A1

## Description

This application claims priority to Chinese patent application No. 202411248353.3, filed with the Chinese Patent Office on September 5, 2024. The disclosure of the abovementioned application is incorporated herein by reference in its entirety.

## TECHNICAL FIELD

The present application relates to the field of battery technology, and in particular to a battery thermal runaway warning method and apparatus, an electronic device and a storage medium.

## BACKGROUND

With the rapid development of the new energy industry, batteries are widely used in electric vehicles, large energy storage systems, etc., and the safety performance of batteries has also received more and more attention. In various extreme conditions of use of a battery, thermal runaway thereof may occur, which may cause personal safety hazards to drivers and passengers.

In the related art, the warning of thermal runaway of a battery is mainly carried out by acquiring the voltage and temperature of the battery at a certain moment and making a simple comparison of the acquired voltage and temperature with respective threshold values.

## SUMMARY

However, in the method of warning of thermal runaway of a battery by acquiring the voltage and temperature of the battery at a certain moment and making a simple comparison of the acquired voltage and temperature with respective threshold values, the acquired voltage or temperature may fail, which may result in misjudgment of thermal runaway. Thus, it is difficult to achieve effective warning of thermal runaway, thereby affecting driving safety.

Embodiments of the present application provide a battery thermal runaway warning method and apparatus, an electronic device and a storage medium capable of implementing effective warning of thermal runaway of a battery, thereby enhancing battery safety.

In a first aspect, according to some embodiments of the present application, a battery thermal runaway warning method includes:

obtaining electrical performance data sequences comprising a plurality of respective sequences of a plurality of types of electrical performance data of a battery to be detected;
performing filtering and detection processing on the electrical performance data sequences to obtain filtered electrical performance data; and
determining whether the battery meets a preset alarm condition based on the filtered electrical performance data, and outputting a warning signal when the battery meets the preset alarm condition.

In a second aspect, according to some embodiments of the present application, a battery thermal runaway warning apparatus includes:

an obtaining module configured to obtain electrical performance data sequences comprising a plurality of respective sequences of a plurality of types of electrical performance data of a battery to be detected;
a filtering module configured to perform filtering and detection processing on the electrical performance data sequences to obtain filtered electrical performance data; and
a determination module configured to determine whether the battery meets a preset alarm condition based on the filtered electrical performance data, and output a warning signal when the battery meets the preset alarm condition.

In a third aspect, according to some embodiments of the present application, an electronic device includes:

one or more processors;
a memory; and
one or more application programs stored in the memory and configured to be executed by the one or more processors to perform steps of the battery thermal runaway warning method in the first aspect.

In a fourth aspect, the present application further provides a computer-readable storage medium having a computer program stored thereon, and the computer program can be loaded by a processor to perform steps of the battery thermal runaway warning method in the first aspect.

In a fifth aspect, the present application further provides a computer program product including a computer program/instructions executable by a processor to perform steps of the battery thermal runaway warning method in the first aspect.

## BENEFICIAL EFFECTS

Beneficial effects of embodiments of the present application:

In embodiments of the present application, the above-mentioned battery thermal runaway warning method comprises: obtaining electrical performance data sequences comprising a plurality of respective sequences of a plurality of types of electrical performance data of a battery to be detected; performing filtering and detection processing on the electrical performance data sequences to obtain filtered electrical performance data; and determining whether the battery meets a preset alarm condition based on the filtered electrical performance data, and outputting a warning signal when the battery meets the preset alarm condition. By performing filtering and detection processing on the electrical performance data sequences, it is possible to filter out erroneous electrical performance data acquired in a unit acquisition cycle, thereby ensuring the accuracy and effectiveness of the filtered electrical performance data. Thus, false alarms of thermal runaway caused by data acquisition errors can be avoided, and the accuracy and effectiveness of the warning of thermal runaway of the battery is improved.

BRIEF DESCRIPTION OF THE DRAWINGS

FIG. 1 is a schematic flowchart of a battery thermal runaway warning method according to some embodiments of the present application.
FIG. 2 is a schematic diagram of filtered temperatures according to some embodiments of the present application.
FIG. 3 is a schematic diagram of filtered voltages according to some embodiments of the present application.
FIG. 4 is a schematic block diagram of a battery thermal runaway warning apparatus according to some embodiments of the present application.
FIG. 5 is a schematic block diagram of an electronic device according to some embodiments of the present application.

DETAILED DESCRIPTION

At present, most methods for warning of thermal runaway usually acquire the voltage and temperature at a certain moment and compare them with the corresponding thresholds for a simple comparison, which will cause the acquired data to be invalid. For example, when the thermal runaway does not occur, the voltage value acquired at a certain moment will be lower than the initial voltage by a preset ratio of, such as 25%, due to a fault in the acquisition equipment such as the battery management system. At this time, the battery thermal runaway fault may be falsely reported, causing the performance of the whole vehicle to decline rapidly, affecting driving safety. Therefore, the present application proposes a battery thermal runaway warning method and apparatus, an electronic device and a storage medium to improve the accuracy of the warning of thermal runaway of a battery.

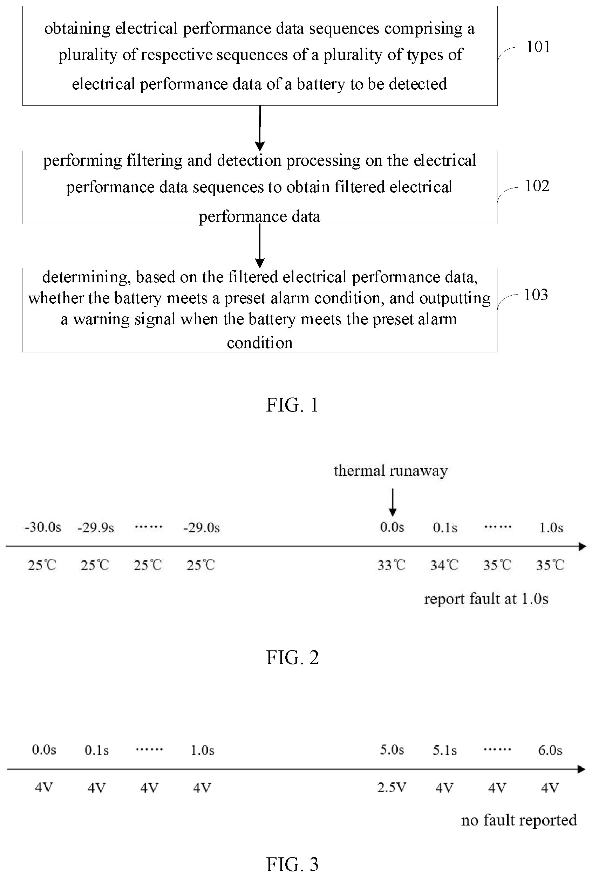

FIG. 1 is a flowchart of a battery thermal runaway warning method according to some embodiments of the present application. The execution subject of the embodiments of the present application is an electrical device or a control module in the electrical device. The control module can be a battery management system (BMS), a vehicle control unit (VCU), etc. The embodiment of the present application is described in detail by taking the execution subject as BMS as an example. The battery thermal runaway warning method includes:
101: Obtaining electrical performance data sequences of a battery to be detected, and the electrical performance data sequences includes sequences corresponding to a plurality of types of electrical performance data.
Among them, the battery to be detected refers to a battery that needs to be detected for thermal runaway, such as an energy storage battery, a lithium battery, etc.
The plurality of types of electrical performance data may include a temperature, a voltage and a voltage acquisition circuit status of the battery, and the voltage acquisition circuit status refers to the status of the voltage sampling circuit used to acquire the battery voltage, such as normal status and abnormal status. Accordingly, the electrical performance data sequences may include a temperature data sequence, a voltage data sequence and a status data sequence. The sequence corresponding to each type of electrical performance data includes electrical performance data arranged in the order of acquisition time. For example, for temperature, the sampling period is 0.1s (seconds), and the temperature data sequence includes the temperatures of 0s, 0.1s, 0.2s...60s, such as [0°C, 25°C, 25°C...25°C]. For voltage and voltage acquisition circuit status, it can be identified by text, letters or numbers, for example, 0 represents normal status and 1 represents abnormal status, and the sampling period is 0.1s (seconds), and the status data sequence includes the status of 0s, 0.1s, 0.2s...60s, such as [0, 1, 1...1].
Specifically, the data sequences corresponding to different types of electrical performance data can be acquired by the BMS to obtain electrical performance data sequences. It can be understood that in this embodiment, by obtaining the electrical performance data sequences, the thermal runaway detection would be performed based on continuous electrical performance data in the future, thereby avoiding a high misjudgment rate of thermal runaway detection caused by failure of a single electrical performance data.
102: Performing filtering and detection processing on the electrical performance data sequences to obtain filtered electrical performance data.
The filtering and detection is a data processing method that analyzes multiple consecutive frames of data to detect whether the data is abnormal.
Specifically, multiple consecutive frames of electrical performance data in the electrical performance data sequences can be compared to achieve multiple detections of the electrical performance data sequences, thereby filtering out erroneous electrical performance data acquired in a unit acquisition cycle, that is, filtering out failed data in the electrical performance data sequences, ensuring the accuracy and effectiveness of the filtered electrical performance data, and avoiding false alarms of thermal runaway caused by data acquisition errors.

103: Determining whether the battery meets a preset alarm condition based on the filtered electrical performance data, and output a warning signal when the preset alarm condition is met.

Among them, the preset alarm condition is a preset condition for detecting whether thermal runaway is triggered, such as the threshold value corresponding to the electrical performance data, the duration of reaching the thermal runaway condition, etc.

Specifically, after obtaining the filtered electrical performance data, it is detected whether the filtered electrical performance data meets the preset alarm condition. If the preset alarm condition is met, indicating that the condition for triggering thermal runaway is met, a warning signal is output to achieve warning of thermal runaway of the battery. It can be understood that in this embodiment, since the filtered electrical performance data is accurate and effective electrical performance data, thermal runaway detection is performed on the filtered electrical performance data to avoid false alarms of thermal runaway caused by data acquisition errors, thereby improving the accuracy and effectiveness of the warning of thermal runaway of the battery.

In one embodiment, the plurality of types of electrical performance data may include a temperature, a voltage, and a voltage acquisition circuit status, the filtered electrical performance data may include a filtered temperature, a filtered voltage, and a filtered status respectively corresponding to the temperature, the voltage, and the voltage acquisition circuit status, and the preset alarm condition may be a first alarm condition or a second alarm condition. Determining whether the battery meets a preset alarm condition according to the filtered electrical performance data may be implemented by: determining whether the battery meets the first alarm condition according to the filtered voltage and the filtered temperature, and outputting a warning signal when the first alarm condition is met; or,

determining whether the battery meets the second alarm condition according to the filtered temperature and the filtered status, and outputting a warning signal when the second alarm condition is met.

Among them, the filtered temperature is the temperature data obtained after performing filtering and detection on the temperature data sequence of the battery, which is used to characterize the temperature of the battery over a period of time. Similarly, the filtered voltage is used to characterize the voltage of the battery over a period of time, and the filtered status is used to characterize the status of the voltage acquisition circuit of the battery over a period of time.

Specifically, when a battery triggers thermal runaway, its temperature will inevitably change suddenly, its voltage will also change suddenly, or the voltage sampling circuit will be burned out to form an open status, that is, an abnormal status. Therefore, in this embodiment, it is determined whether the battery meets the first alarm condition based on the filtered voltage and the filtered temperature. When the first alarm condition is met, a warning signal is output, that is, it is necessary to combine the filtered voltage and the filtered temperature to detect whether the first alarm condition is met, so as to avoid a false alarm of thermal runaway caused by determining that the first alarm condition is met only based on the filtered voltage or the filtered temperature; or, it is determined whether the battery meets the second alarm condition based on the filtered temperature and the filtered status, so as to avoid a false alarm of thermal runaway caused by determining that the second alarm condition is met only based on the filtered temperature or the filtered status, thereby improving the effectiveness and accuracy of the warning of thermal runaway of the battery.

In one embodiment, the electrical performance data sequences may include a temperature data sequence and a voltage data sequence respectively corresponding to the temperature and voltage. The performing of filtering and detection on the electrical performance data sequences to obtain the filtered electrical performance data may be implemented by: selecting N temperature data respectively corresponding to N first filtering moments from the temperature data sequence as reference temperatures, the time intervals between every two adjacent first filtering moments in the N first filtering moments are uniform, and N is a natural number greater than 2; obtaining N comparison temperatures by obtaining a temperature data corresponding to a moment being P moments ahead of one of the N first filtering moments corresponding to each reference temperature from the temperature data sequence as the comparison temperature; obtaining N temperature differences, by calculating a difference between one of the reference temperatures and one of the N comparison temperatures corresponding to each one of the N first filtering moments, as the filtered temperature; selecting M voltage data corresponding to M second filtering moments from the voltage data sequence as reference voltages, and the time intervals between every two adjacent second filtering moments in the M second filtering moments are uniform, and M is a natural number greater than 2; obtaining M comparison voltages by obtaining a temperature data corresponding to a moment being Q moments ahead of one of the M second filtering moments corresponding to each reference voltage from the voltage data sequence as a comparison voltage; obtaining M voltage differences, by calculating a difference between one of the M comparison voltages and one of the reference voltages that are corresponding to each of the M second filtering moments, as the filtered voltage.

Determining whether the battery meets the first alarm condition based on the filtered voltage and the filtered temperatures may be implemented by: when each of the N temperature differences is greater than a preset temperature difference threshold, and each of the M voltage differences is greater than a preset voltage drop threshold, determining that the battery meets the first alarm condition.

There are at least three first filtering moments, which may be $t_1$, $t_2$, ... $t_n$, and the time interval between $t_n$ and $t_{n-1}$ may be the acquisition period of the temperature data in the temperature data sequence or an integer multiple of the acquisition period of the temperature data in the temperature data sequence. For example, the sampling period is 1s. The reference temperature is the temperature data corresponding to moment $t_1$, moment $t_2$, ... moment $t_n$, such as $T_1$, $T_2$, ... $T_n$, and the comparison temperature is the temperature data corresponding to a moment being P moments ahead of the first filtering moment, that is, the temperature data corresponding to $t_{1-P}$, $t_{2-P}$ , ... $t_{n-P}$, such as $T_{1-P}$, $T_{2-P}$, ... $T_{n-P}$. In one example, P moments is 5s.

There are at least three second filtering moments, which may be moment $s_1$, moment $s_2$, ... moment $s_m$, and the time interval between moment $s_m$ and moment $s_{m-1}$ may be the acquisition period of the voltage data in the voltage data sequence or an integer multiple of the acquisition period of the voltage data in the voltage data sequence. For example, the sampling period is 1s. The reference voltage is the voltage data corresponding to moment $s_1$, moment $s_2$, ... moment $s_m$, such as $V_1$, $V_2$, ... $V_m$, and the comparison temperature is the temperature data at a moment which is Q moments ahead of the first filtering moment, that is, the voltage data corresponding to moment $s_{1-Q}$, moment $s_{2-Q}$, ... moment $s_{m-Q}$, such as the $V_{1-Q}$, $V_{2-Q}$, ... $V_{m-Q}$. In one example, Q moments is 20s.

The preset temperature difference threshold is a critical temperature difference preset to determine whether thermal runaway is triggered, such as 8° C. The preset voltage drop threshold is a critical voltage drop preset to determine whether thermal runaway is triggered, such as 1.5V.

Specifically, the process of calculating the filtered temperature is as following step S1:
For each first filtering moment, the difference between the comparison temperature and the reference temperature is calculated to obtain N temperature differences, namely, the temperature differences $\Delta T_{t1}$, $\Delta T_{t2}$, ... $\Delta T_{tn}$ respectively corresponding to the moments $t_1$, $t_2$, ... $t_n$ are calculated by the following formula:

$$\Delta T_{t1} = T_1 - T_{1-P};$$

$$\Delta T_{t2} = T_2 - T_{2-P};$$

$$\Delta T_{tn} = T_n - T_{n-P};$$

Therefore, $\Delta T_{t1}$, $\Delta T_{t2}$, ... $\Delta T_{tn}$ are calculated. FIG. 2 is a schematic diagram of the filtered temperature.

The process of calculating the filtered voltage is as following step S2: For each second filtering moment, the difference between the comparison voltage and the reference voltage is calculated to obtain M voltage differences, namely, the voltage differences $\Delta V_{s1}$, $\Delta V_{s2}$ ...... $\Delta V_{sm}$ respectively corresponding to the moment $s_1$, moment $s_2$ ... moment $s_m$ are calculated by the following formula:

$$\Delta V_{s1} = V_{1-Q} - V_1;$$

$$\Delta V_{s2} = V_{2-Q} - V_2;$$

$$\Delta V_{sm} = V_{m-Q} - V_m;$$

Therefore, $\Delta V_{s1}$, $\Delta V_{s2}$ ...... $\Delta V_{sm}$ are calculated. FIG. 3 is a schematic diagram of the filtered voltage.

Specifically, when each of the N temperature differences of the filtered temperature is greater than the preset temperature difference threshold, and each of the M voltage differences is greater than the preset voltage drop threshold, it is determined that the first alarm condition is met and a warning signal is output. It can be understood that in this embodiment, by detecting whether the temperature rise value of the battery within the P moments is greater than the preset temperature difference threshold, if so, it is determined that there is a fault, and the fault exists at each one of the N first filtering moments. At the same time, it is detected whether the voltage drop value of the battery within the Q moments is greater than the preset voltage drop threshold. If so, it is determined that there is a fault, and the fault exists at each one of the M second filtering moments. That is, two conditions are met at the same time, i.e., the filtered temperatures are greater than the preset temperature difference threshold, and the filtered voltages are greater than the preset voltage drop threshold, then it is determined that the first alarm condition is met, and a warning signal is output, ensuring the accuracy and effectiveness of the warning of thermal runaway.

In one embodiment, the electrical performance data sequences may include a temperature data sequence and a status data sequence respectively corresponding to the temperature and the voltage acquisition circuit status. The performing of filtering and detection processing on the electrical performance data sequences to obtain the filtered electrical performance data may be implemented by: obtaining the filtered status by obtaining a segment of status data for a first preset duration from the status data sequence; selecting N temperature data respectively corresponding to the N first filtering moments from the temperature data sequence as reference temperatures, and the time intervals between every two adjacent first filtering moments in the N first filtering moments are uniform, and N is a natural number greater than 2; obtaining N comparison temperatures by obtaining a temperature data corresponding to a moment being P moments ahead of one of the N first filtering moments corresponding to each reference temperature from the temperature data sequence as a comparison temperature; obtaining N temperature differences, by calculating a difference between one of the reference temperatures and one of the N comparison temperatures that are corresponding to each first filtering moments, as the filtered temperature.

Determining whether the battery meets the second alarm condition based on the filtered temperature and the filtered status may be implemented by: when each of the N temperature differences is greater than a preset temperature difference threshold, and each status data in the filtered status is a preset status data, determining that the second alarm condition is met.

The first preset duration is a preset duration for which determining the status, such as 15 seconds. The preset status data is an abnormal status.

Specifically, the process of calculating the filtered status is as following step S3: obtaining the filtered status by obtaining a segment of status data for a first preset duration from the status data sequence.

The method of calculating the filtered temperature in this embodiment is same as step S1 in the above embodiment, which will not be described in detail here.

More specifically, when each of the N temperature differences is greater than the preset temperature difference threshold, and each status data in the filtered status is the preset status data, it is determined that the second alarm condition is met and a warning signal is output. It can be understood that in this embodiment, by detecting whether the temperature rise value of the battery within the P moments is greater than the preset temperature rise threshold, if so, it is determined that a fault exists, and the fault exists at each one of the N first filtering moments, and the duration of the filtered status being the preset status data is the first preset duration, it is determined that the second alarm condition is met, and a warning signal is output, thereby ensuring the accuracy and effectiveness of the warning of thermal runaway.

In one embodiment, the electrical performance data sequences may include a temperature data sequence and a status data sequence respectively corresponding to the temperatures and the voltage acquisition circuit status. The performing of filtering and detection processing on electrical performance data sequence to obtain the filtered electrical performance data may be implemented by: obtaining filtered status by obtaining a segment of status data for a first preset duration from the status data sequence; and obtaining the filtered temperature by obtaining a segment of temperature data for a second preset duration.

Determining whether the battery meets the second alarm condition based on the filtered temperature and the filtered status may be implemented by: when each temperature data in the filtered temperatures is greater than the preset temperature, and each status data in the filtered status is the preset status data, determining that the second alarm condition is met.

The second preset duration is a preset duration for which determining that the temperature is within a preset range, such as 3 seconds. The preset temperature is a preset critical temperature for determining whether thermal runaway is triggered, such as 65°C.

Specifically, the process of calculating the filtered temperatures is as following step S4: obtaining the filtered temperature by obtaining a segment of temperature data for a second preset duration from the temperature data sequence.

The method of calculating the filtered status in this embodiment is same as step S3 in the above embodiment, which will not be described in detail here.

More specifically, when each temperature data in the filtered temperature is greater than the preset temperature, and each status data in the filtered status is the preset status data, it is determined that the second alarm condition is met and a warning signal is output. It can be understood that in this embodiment, by detecting that the duration of the filtered temperature being greater than the preset temperature is the second preset duration, and the duration of the filtered status being the preset status data is the first preset duration, it is determined that the second alarm condition is met and a warning signal is output, thereby ensuring the accuracy and effectiveness of the warning of thermal runaway.

In one embodiment, the electrical performance data sequences may include a temperature data sequence and a status data sequence respectively corresponding to the temperatures and the voltage acquisition circuit status. The performing of filtering and detection processing on the electrical performance data sequences to obtain the filtered electrical performance data may be implemented by: obtaining the filtered status by obtaining a segment of status data for a first preset duration from the status data sequence; obtaining a temperature rise rate sequence by calculating a temperature rise rate between two adjacent temperature data in the temperature data sequence; and obtaining the filtered temperature by obtaining a segment of temperature rise rate for a third preset duration from the temperature rise rate sequence.

Determining whether the battery meets the second alarm condition based on the filtered temperatures and the filtered status may be implemented by: when each temperature rise rate in the filtered temperature is greater than a preset rate, and each status data in the filtered status is preset status data, determining that the second alarm condition is met.

The third preset duration is a preset duration for which determining the temperature rise rate within a preset range, such as 3s. The preset rate is a preset critical temperature rise rate for determining whether thermal runaway is triggered, such as 1°C/s.

Specifically, the process of calculating the filtered temperature is as following step S5: obtaining the temperature rise rate sequence by calculating a temperature rise rate between two adjacent temperature data in the temperature data sequence, and obtaining the filtered temperature by obtaining a segment of temperature rise rates for a third preset duration from the temperature rise rate sequence.

The method of calculating the filtered status in this embodiment is same as step S3 in the above embodiment, which will not be described in detail here.

More specifically, when each temperature rise rate in the filtered temperature is greater than the preset rate, and each status data in the filtered status is the preset status data, it is determined that the second alarm condition is met and a warning signal is output. It can be understood that in this embodiment, by detecting that the duration of the temperature rise rate in the filtered temperature being greater than the preset rate is the third preset duration, and the duration of the filtered status being the preset status data is the first preset duration, it is determined that the second alarm condition is met and a warning signal is output, thereby ensuring the accuracy and effectiveness of the warning of thermal runaway.

In one embodiment, the electrical performance data sequences may include a temperature data sequence and a voltage data sequence respectively corresponding to the temperature and the voltage. The performing of filtering and detection processing on the electrical performance data sequences to obtain the filtered electrical performance data may be implemented by: selecting N temperature data respectively corresponding to N first filtering moments from the temperature data sequence as reference temperatures, and the time intervals between every two adjacent first filtering moments in the N first filtering moments are uniform, and N is a natural number greater than 2; obtaining N comparison temperatures by obtaining a temperature data corresponding to a moment being P moments ahead of one of the N first filtering moments corresponding to each reference temperature from the temperature data sequence as a comparison temperature; obtaining N temperature differences, calculating a difference between one of the reference temperatures and one of the N comparison temperatures, as the filtered temperature; and obtaining the filtered voltage by obtaining a segment of voltage data for a fourth preset duration from the voltage data sequence.

Determining whether the battery meets the first alarm condition based on the filtered voltage and the filtered temperature may be implemented by: when each of the N temperature differences is greater than a preset temperature difference threshold, and each voltage data in the filtered voltage is less than or equal to a preset voltage threshold, determining that the first alarm condition is met.

The fourth preset duration is a preset duration for which determining that the voltage is within a preset range, such as 3s. The preset voltage threshold is a preset critical voltage for determining whether thermal runaway is triggered, such as 1.5V.

Specifically, the process of calculating the filtered voltage is as following step S6: obtain the filtered voltage by obtaining a segment of voltage data for a fourth preset duration from the voltage data sequence.

The method of calculating the filtered temperature in this embodiment is same as step S1 in the above embodiment, which will not be described in detail here.

More specifically, when each of the N temperature differences is greater than the preset temperature difference threshold, and each voltage data in the filtered voltage is less than or equal to the preset voltage threshold, a warning signal is output. It can be understood that in this embodiment, by detecting whether the temperature rise value of the battery within the P moments is greater than the preset temperature difference threshold, if so, it is determined that there is a fault, and the duration of the voltage data in the filtered voltage being less than or equal to the preset voltage threshold is the fourth preset duration, it is determined that the first alarm condition is met, and a warning signal is output, thereby ensuring the accuracy and effectiveness of the warning of thermal runaway.

In one embodiment, the electrical performance data sequences may include a temperature data sequence and a voltage data sequence respectively corresponding to the temperature and voltage. The performing of filtering and detection processing on the electrical performance data sequences to obtain the filtered electrical performance data may be implemented by: obtaining a temperature rise rate sequence by calculating a temperature rise rate between two adjacent temperature data in the temperature data sequence; obtaining the filtered temperature by obtaining a segment of temperature rise rates for a third preset duration from the temperature rise rate sequence; selecting M voltage data respectively corresponding to M second filtering moments from the voltage data sequence as reference voltages, and the time intervals between every two adjacent second filtering moments in the M second filtering moments are uniform, and M is a natural number greater than 2; obtaining M comparison voltages by obtaining a voltage data corresponding to a moment being Q moments ahead of each one of the M second filtering moment corresponding to each reference voltage from the voltage data sequence as a comparison voltage; obtaining M voltage differences, by calculating a difference between one of the M comparison voltages and one of the reference voltages that are corresponding to each one of the M second filtering moments, as the filtered voltage.

Determining whether the battery meets the first alarm condition based on the filtered voltage and the filtered temperature may be implemented by: when each temperature rise rate in the filtered temperature is greater than a preset rate, and each one of the M voltage differences is greater than a preset voltage drop threshold, determining that the first alarm condition is met.

The method of calculating the filtered temperature in this embodiment is same as step S5 in the above embodiment, which will not be described again here.

The method of calculating the filtered voltage in this embodiment is same as step S2 in the above embodiment, which will not be described again here.

Specifically, when each temperature rise rate in the filtered temperature is greater than the preset rate, and each one of the M voltage differences is greater than the preset voltage drop threshold, it is determined that the first alarm condition is met and a warning signal is output. It can be understood that in this embodiment, by detecting whether the voltage drop value of the battery within the Q moments is greater than the preset voltage drop threshold, if so, it is determined that a fault exists, and the fault exists at each of the M second filtering moments, and the duration of temperature rise rate in the filtered temperature greater than the preset rate is the third preset duration, it is determined that the first alarm condition is met, and a warning signal is output, ensuring the accuracy and effectiveness of the warning of thermal runaway.

In one embodiment, the electrical performance data sequences may include a temperature data sequence and a voltage data sequence respectively corresponding to the temperature and voltage. The performing of filtering and detection processing on the electrical performance data sequences to obtain the filtered electrical performance data may be implemented by: obtaining a temperature rise rate sequence by calculating a temperature rise rate between two adjacent temperature data in the temperature data sequence; obtaining filtered temperature by obtaining a segment of temperature rise rates for a third preset duration from the temperature rise rate sequence; and obtaining the filtered voltage by obtaining a segment of voltage data for a fourth preset duration from the voltage data sequence.

Determining whether the battery meets the first alarm condition based on the filtered voltage and the filtered temperature may be implemented by: when each temperature rise rate in the filtered temperature is greater than a preset rate, and each voltage data in the filtered voltage is less than or equal to a preset voltage threshold, determining that the first alarm condition is met.

The method of calculating the filtered temperature in this embodiment is same as step S5 in the above embodiment, which will not be described again here.

The method of calculating the filtered voltage in this embodiment is same as step S6 in the above embodiment, which will not be described in detail here.

Specifically, when each temperature rise rate in the filtered temperature is greater than the preset rate, and each voltage data in the filtered voltage is less than or equal to the preset voltage threshold, it is determined that the first alarm condition is met and a warning signal is output. It can be understood that in this embodiment, by detecting that the duration of the voltage data in the filtered voltage being less than or equal to the preset voltage threshold is the fourth preset duration, and the duration of temperature rise rate in the filtered temperature being greater than the preset rate is the third preset duration, it is determined that the first alarm condition is met and a warning signal is output, thereby ensuring the accuracy and effectiveness of the warning of thermal runaway.

In one embodiment, the electrical performance data sequences may include a temperature data sequence and a voltage data sequence respectively corresponding to the temperature and the voltage. The performing of filtering and detection processing on the electrical performance data sequences to obtain the filtered electrical performance data may be implemented by: obtain the filtered temperature by obtaining a segment of temperature data for a second preset duration from the temperature data sequence; selecting M voltage data respectively corresponding to M second filtering moments from the voltage data sequence as reference voltages, and the time intervals between every two adjacent second filtering moments in the M second filtering moments are uniform, and M is a natural number greater than 2; obtaining M comparison voltages by obtaining a voltage data corresponding to a moment being Q moments ahead of one of the M second filtering moments corresponding to each reference voltages from the voltage data sequence as a comparison voltage; obtaining M voltage differences, by calculating a difference between one of the M comparison voltages and one of the reference voltages that are corresponding to each one of the M second filtering moments, as the filtered voltage.

Determining whether the battery meets the first alarm condition based on the filtered voltages and the filtered temperatures may be implemented by:
when each temperature data in the filtered temperature is greater than the preset temperature, and each one of the M voltage difference values is greater than the preset voltage drop threshold, it is determined that the first alarm condition is met.

The method of calculating the filtered temperature in this embodiment is same as step S4 in the above embodiment, which will not be described again here.

The method of calculating the filtered voltage in this embodiment is same as step S2 in the above embodiment, which will not be described again here.

Specifically, when each temperature data in the filtered temperature is greater than the preset temperature, and each voltage data in the filtered voltage is less than or equal to the preset voltage threshold, it is determined that the first alarm condition is met and a warning signal is output. It can be understood that in this embodiment, by detecting whether the voltage drop value of the battery within the Q moments is greater than the preset voltage drop threshold, if so, it is determined that there is a fault, and the fault exists at each one of the M second filtering moments, and the duration of the filtered temperature being greater than the preset temperature is the second preset duration, it is determined that the first alarm condition is met, and a warning signal is output, ensuring the accuracy and effectiveness of the warning of thermal runaway.

In one embodiment, the electrical performance data sequences may include a temperature data sequence and a voltage data sequence respectively corresponding to the temperature and voltage. The performing of filtering and detection processing on the electrical performance data sequences to obtain the filtered electrical performance data may be implemented by: obtaining the filtered voltage by obtaining a segment of voltage data for a fourth preset duration from the voltage data sequence; and obtaining the filtered temperature by obtaining a segment of temperature data for a second preset duration from the temperature data sequence.

Determining whether the battery meets the first alarm condition based on the filtered voltage and the filtered temperature may be implemented by: when each temperature data in the filtered temperature is greater than the preset temperature, and each voltage data in the filtered voltage is less than or equal to the preset voltage threshold, determining that the first alarm condition is met.

The method of calculating the filtered temperature in this embodiment is same as step S4 in the above embodiment, which will not be described again here.

The method of calculating the filtered voltage in this embodiment is same as step S6 in the above embodiment, which will not be described in detail here.

Specifically, when each temperature data in the filtered temperature is greater than the preset temperature, and each voltage data in the filtered voltage is less than or equal to the preset voltage threshold, it is determined that the first alarm condition is met and a warning signal is output. It can be understood that in this embodiment, by detecting that the duration of the filtered temperature being greater than the preset temperature is the second preset duration, and the duration of the voltage data in the filtered voltage being less than or equal to the preset voltage threshold is the fourth preset duration, it is determined that the first alarm condition is met and a warning signal is output, thereby ensuring the accuracy and effectiveness of the warning of thermal runaway.

The above-mentioned battery thermal runaway warning method obtains the electrical performance data sequences of the battery to be detected, the electrical performance data sequences includes sequences corresponding to a plurality of types of electrical performance data; performs filtering and detection processing on the electrical performance data sequences to obtain the filtered electrical performance data; determines whether the battery meets a preset alarm condition based on the filtered electrical performance data, and outputs a warning signal when the preset alarm condition is met. By performing filtering and detection processing on the electrical performance data sequences, it is possible to filter out erroneous electrical performance data acquired in a unit acquisition cycle, thereby ensuring the accuracy and effectiveness of the filtered electrical performance data, avoiding false alarms of thermal runaway caused by data acquisition errors, and improving the accuracy and effectiveness of warning of thermal runaway of the battery.

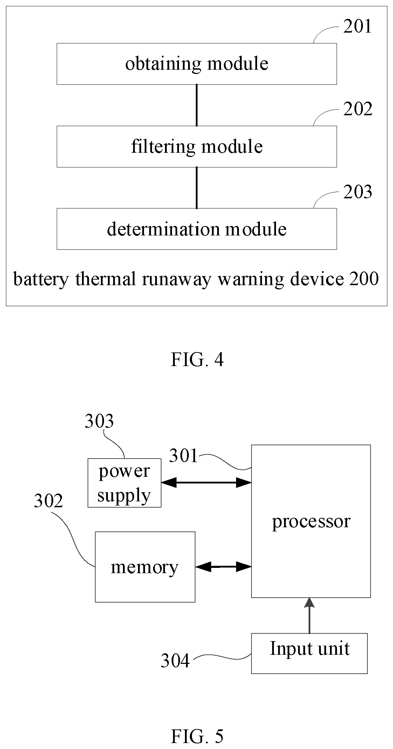

As shown in FIG. 4, a device 200 for warning of thermal runaway of a battery according to the embodiments of the present application includes:

an obtaining module 201 configured to obtain electrical performance data sequences of a battery to be detected, and the electrical performance data sequences includes sequences corresponding to a plurality of types of electrical performance data;
a filtering module 202 configured to perform filtering and detection processing on the electrical performance data sequences to obtain the filtered electrical performance data; and
a determination module 203 configured to determine whether the battery meets a preset alarm condition based on the filtered electrical performance data, and output a warning signal when the preset alarm condition is met.

In one embodiment, the plurality of types of electrical performance data include a temperature, a voltage, and a voltage acquisition circuit status, the filtered electrical performance data include a filtered temperature, a filtered voltage, and a filtered status respectively corresponding to the temperature, the voltage, and the voltage acquisition circuit status, and the preset alarm condition may be a first alarm condition or a second alarm condition. The determination module 203 is configured to

determine whether the battery meets a preset alarm condition based on the filtered electrical performance data, which is specifically configured to:
determine whether the battery meets the first alarm condition based on the filtered voltage and the filtered temperature, and output a warning signal when the first alarm condition is met; or,
determine whether the battery meets the second alarm condition based on the filtered temperature and the filtered status, and output a warning signal when the second alarm condition is met.

In one embodiment, the electrical performance data sequences may include a temperature data sequence and a voltage data sequence respectively corresponding to the temperature and the voltage. The filtering module 202 is configured to:

select N temperature data respectively corresponding to N first filtering moments from the temperature data sequence as reference temperatures, the time intervals between every two adjacent first filtering moments in the N first filtering moments are uniform, and N is a natural number greater than 2;

obtain N comparison temperatures by obtaining a temperature data corresponding to a moment being P moments ahead of one of the N first filtering moments corresponding to each reference temperature from the temperature data sequence as the comparison temperature;

obtain N temperature differences, by calculating a difference between one of the reference temperatures and one of the N comparison temperatures that are corresponding to each one of the N first filtering moments, as the filtered temperature;

select M voltage data respectively corresponding to M second filtering moments from the voltage data sequence as reference voltages, the time intervals between every two adjacent second filtering moments in the M second filtering moments are uniform, and M is a natural number greater than 2;

obtain M comparison voltages by obtaining a voltage data corresponding to a moment being Q moments ahead of one of the M second filtering moments corresponding to each reference voltage from the voltage data sequence as a comparison voltage; and

obtain M voltage differences, by calculating a difference between one of the M comparison voltages and one of the reference voltages that are corresponding to each one of the M second filtering moments, as the filtered voltage.

The determination module 203 is configured to: when each one of the N temperature differences is greater than the preset temperature difference threshold, and each one of the M voltage differences is greater than the preset voltage drop threshold, it is determined that the first alarm condition is met.

In one embodiment, the electrical performance data sequences may include a temperature data sequence and a status data sequence respectively corresponding to the temperature and the voltage acquisition circuit status. The filtering module 202 is further specifically configured to:

obtain the filtered status by obtaining a segment of status data for a first preset duration from the status data sequence;

select N temperature data respectively corresponding to N first filtering moments from the temperature data sequence as reference temperatures, the time intervals between every two adjacent filtering moments in the N first filtering moments are uniform, and N is a natural number greater than 2;

obtain N comparison temperatures by obtaining a temperature data corresponding to a moment being P moments ahead of one of the N first filtering moments corresponding to each reference temperature from the temperature data sequence as a comparison temperature; and

obtain N temperature differences, by calculating a difference between one of the reference temperatures and one of the N comparison temperatures that are corresponding to each one of the N first filtering moments, as the filtered temperature.

The determination module 203 is configured to: when each one of the N temperature differences is greater than the preset temperature difference threshold, and each status data in the filtered status is the preset status data, it is determined that the second alarm condition is met.

In one embodiment, the electrical performance data sequences may include a temperature data sequence and a status data sequence respectively corresponding to the temperature and voltage acquisition circuit status. The filtering module 202 is further specifically configured to:

obtain the filtered status by obtaining a segment of status data for a first preset duration from the status data sequence; and

obtain the filtered temperature by obtaining a segment of temperature data for a second preset duration from the temperature data sequence.

The determination module 203 is configured to: when each temperature data in the filtered temperature is greater than the preset temperature, and each status data in the filtered status is the preset status data, it is determined that the second alarm condition is met.

In one embodiment, the electrical performance data sequences may include a temperature data sequence and a status data sequence respectively corresponding to the temperature and voltage acquisition circuit status. The filtering module 202 is further specifically configured to:

obtain the filtered status by obtaining a segment of status data for a first preset duration from the status data sequence;

obtain a temperature rise rate sequence by calculating a temperature rise rate between every two adjacent temperature data in the temperature data sequence ; and

obtain the filtered temperature by obtaining a segment of temperature rise rates for a third preset time period from the temperature rise rate sequence.

The determination module 203 is configured to: when each temperature rise rate in the filtered temperature is greater than a preset rate, and each status data in the filtered status is preset status data, it is determined that the second alarm condition is met.

In one embodiment, the electrical performance data sequences may include a temperature data sequence and a voltage data sequence respectively corresponding to the temperature and the voltage. The filtering module 202 is configured to:

select N temperature data respectively corresponding to N first filtering moments from the temperature data sequence as reference temperatures, the time intervals between every two adjacent filtering moments in the N first filtering moments is the same, and N is a natural number greater than 2;

obtain N comparison temperatures by obtaining a temperature data corresponding to a moment being P moments ahead of one of the N first filtering moments corresponding to each reference temperature from the temperature data sequence as a comparison temperature;

obtain N temperature differences, by calculating a difference between one of the reference temperatures and one of the N comparison temperatures that are corresponding to each one of the N first filtering moments, as the filtered temperature; and

obtain the filtered voltage by obtaining a segment of voltage data for a fourth preset duration from the voltage data sequence.

The determination module 203 is configured to: when each one of the N temperature differences is greater than the preset temperature difference threshold, and each voltage data in the filtered voltage is less than or equal to the preset voltage threshold, it is determined that the first alarm condition is met.

In one embodiment, the electrical performance data sequences may include a temperature data sequence and a voltage data sequence respectively corresponding to the temperature and the voltage. The filtering module 202 is configured to:

obtain a temperature rise rate sequence by calculating a temperature rise rate between every two adjacent temperature data in the temperature data sequence;

obtain the filtered temperature by obtain a segment of temperature rise rates for a third preset time period from the temperature rise rate sequence;

selecting M voltage data respectively corresponding to M second filtering moments from the voltage data sequence as reference voltages, the time intervals between every two adjacent filtering moments in the M second filtering moments are uniform, and M is a natural number greater than 2;

obtain M comparison voltages by obtaining a voltage data corresponding to a moment being Q moments ahead of one of the M second filtering moments corresponding to each reference voltage from the voltage data sequence as a comparison voltage; and

obtain M voltage differences, by calculating a difference between one of the M comparison voltages and one of the reference voltages that are corresponding to each one of the M second filtering moments, as the filtered voltage.

The determination module 203 is configured to: when each temperature rise rate in the filtered temperature is greater than a preset rate, and each one of the M voltage differences is greater than a preset voltage drop threshold, it is determined that the first alarm condition is met.

In one embodiment, the electrical performance data sequences may include a temperature data sequence and a voltage data sequence respectively corresponding to the temperature and the voltage. The filtering module 202 is configured to:

obtain a temperature rise rate sequence by calculating a temperature rise rate between every two adjacent temperature data in the temperature data sequence;

obtain a segment of temperature rise rates for a third preset time period from the temperature rise rate sequence to obtain the filtered temperature; and

obtain the filtered voltage by obtaining a segment of voltage data for a fourth preset duration from the voltage data sequence.

The determination module 203 is configured to: when each temperature rise rate in the filtered temperature is greater than a preset rate, and each voltage data in the filtered voltage is less than or equal to a preset voltage threshold, it is determined that the first alarm condition is met.

In one embodiment, the electrical performance data sequences may include a temperature data sequence and a voltage data sequence respectively corresponding to the temperature and the voltage. The filtering module 202 is configured to:

obtain the filtered temperature by obtaining a segment of temperature data for a second preset duration from the temperature data sequence;

selecting M voltage data respectively corresponding to M second filtering moments from the voltage data sequence as reference voltages, the time intervals between every two adjacent filtering moments in the M second filtering moments are uniform, and M is a natural number greater than 2;

obtain M comparison voltages by obtaining a voltage data corresponding to a moment being Q moments ahead of one of the M second filtering moments corresponding to each reference voltage from the voltage data sequence as a comparison voltage; and

obtain M voltage differences, by calculating a difference between one of the M comparison voltages and one of the reference voltages that are corresponding to each one of the M second filtering moments, as the filtered voltage.

The determination module 203 is configured to:

when each temperature data in the filtered temperature is greater than the preset temperature, and each one of the M voltage difference is greater than the preset voltage drop threshold, it is determined that the first alarm condition is met.

In one embodiment, the electrical performance data sequences may include a temperature data sequence and a voltage data sequence respectively corresponding to the temperature and the voltage. The filtering module 202 is configured to:

obtain filtered voltage by obtaining a segment of voltage data for a fourth preset duration from the voltage data sequence; and
obtain filtered temperature by obtaining a segment of temperature data for a second preset duration from the temperature data sequence.

The determination module 203 is configured to: when each temperature data in the filtered temperature is greater than the preset temperature, and each voltage data in the filtered voltage is less than or equal to the preset voltage threshold, it is determined that the first alarm condition is met.

The embodiments of the present application further provides an electronic device, which integrates any one of the devices for warning of thermal runaway of a battery provided in the embodiments of the present application. The electronic device includes:

one or more processors;
a memory; and
one or more applications stored in the memory and configured to be executed by the processor to implement the battery thermal runaway warning method in any of the above method embodiments.

The embodiments of the present application further provides an electronic device, which integrates any one of the devices for warning of thermal runaway of a battery provided in the embodiments of the present application. FIG. 5 is a schematic block diagram of an electronic device according to some embodiments of the present application, as described below in detail.

The electronic device may include a processor 301 with one or more processing cores, a memory 302 with one or more computer-readable storage media, a power supply 303, and an input unit 304. Those skilled in the art would understand that the electronic device structure shown in FIG. 5 does not constitute a limit to the electronic device, and the electronic device may include more or fewer components than shown in the figure, or combine certain components, or arrange the components differently.

Among them, The processor 301 is the control center of the electronic device. It uses various interfaces and lines to connect various parts of the entire electronic device. By running or executing software programs and/or modules stored in the memory 302, and calling data stored in the memory 302, it executes various functions of the electronic device and processes data, thereby monitoring the electronic device overall. Optionally, the processor 301 may include one or more processing cores. Preferably, the processor 301 may integrate an application processor and a modem processor, the application processor mainly used for the operating system, user interface, and application programs, and the modem processor mainly used for wireless communications. It is understandable that the above-mentioned modem processor may not be integrated into the processor 301.

The memory 302 may be used to store software programs and modules. The processor 301 executes various functional applications and data processing by running the software programs and modules stored in the memory 302. The memory 302 may mainly include a program storage area and a data storage area. The program storage area can store an operating system, an application required for at least one function (such as a sound playback function, an image playback function, etc.), etc.; and the data storage area can store data created according to the use of the electronic device, etc. In addition, the memory 302 may include a high-speed random access memory, and may also include a non-volatile memory, such as at least one disk storage device, a flash memory device, or other volatile solid-status storage devices. Accordingly, the memory 302 may also include a memory controller to provide the processor 301 with access to the memory 302.

The electronic device also includes a power supply 303 for supplying power to each component. Preferably, the power supply 303 can be logically connected to the processor 301 through a power management system, so as to manage charging, discharging, and power consumption through the power management system. The power supply 303 may also include one or more direct current or alternating current power supplies, recharging systems, power failure detection circuits, power converters or inverters, power status indicators, and other arbitrary components.

The electronic device may further include an input unit 304, which may be used to receive input digital or character information and generate keyboard, mouse, joystick, optical or trackball signal input related to user settings and function control.

Although not shown, the electronic device may further include a display unit, etc., which will not be described in detail herein. Specifically in this embodiment, according to the following instructions, the processor 301 in the electronic device will load the executable files corresponding to the processes of one or more application programs into the memory 302, and the processor 301 will run the application programs stored in the memory 302, thereby realizing various functions:

obtaining electrical performance data sequences of a battery to be detected, the electrical performance data sequences includes sequences corresponding to a plurality of types of electrical performance data; performing filtering and detection processing on the electrical performance data sequences to obtain the filtered electrical performance data; and determine whether the battery meets a preset alarm condition based on the filtered electrical performance data, and outputting a warning signal when the preset alarm condition is met.

A person of ordinary skill in the art would understand that all or part of the steps in the various methods of the above embodiments may be accomplished by instructions, or by controlling related hardware through instructions. The instructions may be stored in a computer-readable storage medium and loaded and executed by a processor.

To this end, the embodiments of the present application provides a computer-readable storage medium, which may include: a read-only memory (ROM), a random access memory (RAM), a disk or an optical disk, etc. A computer program is stored on the computer-readable storage medium, and the computer program is loaded by a processor to execute the steps in any of the methods for warning of thermal runaway of a battery provided in the embodiments of the present application. For example, the computer program loaded by the processor can execute the following steps:

obtaining electrical performance data sequences of a battery to be detected, the electrical performance data sequences includes sequences corresponding to a plurality of types of electrical performance data; performing filtering and detection processing on the electrical performance data sequences to obtain the filtered electrical performance data; and determine whether the battery meets a preset alarm condition based on the filtered electrical performance data, and outputting a warning signal when the preset alarm condition is met.

The embodiments of the present application further provides a computer program product including a computer program/instruction, which, when executed by a processor, is used to execute the steps in any one of the methods for warning of thermal runaway of a battery provided in the embodiments of the present application.

In the above embodiments, the description of each embodiment has its own emphasis. For parts that are not described in detail in a certain embodiment, please refer to the detailed description of other embodiments above, and will not be repeated here.

In specific implementation, the above units or structures can be implemented as independent entities, or can be arbitrarily combined to be implemented as the same or several entities. For the specific implementation of the above units or structures, the previous method embodiments can be referred to, and repeated description thereof is omitted herein.

Some embodiments of the present application have been described in detail above. Specific examples are used in this disclosure to explain the principles and implementation methods of the present application. The description of the above embodiments aims only to help understand the methods and the core idea of the present application. Moreover, various changes in the specific implementation method and the application scope may occur to those skilled in the art based on the idea of the present application. In summary, the content of this specification should not be construed as limitation to the present application.

**Claims**

1.   A battery thermal runaway warning method, comprising:

obtaining electrical performance data sequences comprising a plurality of respective sequences of a plurality of types of electrical performance data of a battery to be detected; performing filtering and detection processing on the electrical performance data sequences to obtain filtered electrical performance data; and determining, based on the filtered electrical performance data, whether the battery meets a preset alarm condition, and outputting a warning signal when the battery meets the preset alarm condition.

2.   The battery thermal runaway warning method according to claim 1, wherein the plurality of types of the electrical performance data comprise temperature data, voltage data, and status data of a voltage acquisition circuit; the filtered electrical performance data comprises filtered temperature data, filtered voltage data and filtered status data respectively corresponding to the temperature data, the voltage data and the status data; and the preset alarm condition is a first alarm condition or a second alarm condition; and the determining of whether the battery meets the preset alarm condition based on the filtered electrical performance data comprises:

determining whether the battery meets the first alarm condition based on the filtered voltage data and the filtered temperature data, and outputting the warning signal when the battery meets the first alarm condition; or determining whether the battery meets the second alarm condition based on the filtered temperature data and the filtered status data, and outputting the warning signal when the battery meets the second alarm condition.

3. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

selecting N temperature data respectively corresponding to N first filtering moments from the temperature data sequence as reference temperatures, wherein a time interval between every two adjacent ones of the N first filtering moments is uniform, and N is a natural number greater than 2; obtain N comparison temperatures by, for each of the reference temperatures, obtaining temperature data corresponding to a moment being P moments ahead of one of the N first filtering moments corresponding to the each of the reference temperatures from the temperature data sequence as one of the N comparison temperatures; obtaining N temperature differences by, for each of the N first filtering moments, calculating a difference between one of the reference temperatures corresponding to the each of the N first filtering moments and one of the N comparison temperatures corresponding to the each of the N first filtering moments as one of the N temperature differences, and taking the N temperature differences as the filtered temperature data; selecting M voltage data respectively corresponding to M second filtering moments from the voltage data sequence as reference voltages, wherein a time interval between every two adjacent ones of the M second filtering moments is uniform, and M is a natural number greater than 2; obtaining M comparison voltages by, for each of the reference voltages, obtaining voltage data corresponding to a moment being Q moments ahead of one of the M second filtering moments corresponding to the each of the reference voltages from the voltage data sequence as one of the M comparison voltages; and obtaining M voltage differences by, for each of the M second filtering moments, calculating a difference between one of the M comparison voltages corresponding to the each of the M second filtering moments and one of the reference voltages corresponding to the each of the M second filtering moments as one of the M voltage differences, and taking the M voltage differences as the filtered voltage data; and

the determining of whether the battery meets the first alarm condition based on the filtered voltage data and the filtered temperature data comprises:
when each of the N temperature differences is greater than a preset temperature difference threshold and each of the M voltage differences is greater than a preset voltage drop threshold, determining that the battery meets the first alarm condition.

4. The battery thermal runaway warning method according to claim 2, wherein the electrical performance data sequences comprise a temperature data sequence and a status data sequence respectively corresponding to the temperature data and the status data;

the performing of the filtering and detection processing on the electrical performance data sequences to obtain the filtered electrical performance data comprises:

obtaining the filtered status data by obtaining a segment of status data for a first preset duration from the status data sequence; selecting N temperature data respectively corresponding to N first filtering moments from the temperature data sequence as reference temperatures, wherein a time interval between every two adjacent ones of the N first filtering moments is uniform, and N is a natural number greater than 2; obtaining N comparison temperatures by, for each of the reference temperatures, obtaining temperature data corresponding to a moment being P moments ahead of one of the N first filtering moments corresponding to the each of the reference temperatures from the temperature data sequence as one of the N comparison temperatures; and obtain N temperature differences by, for each of the N first filtering moments, calculating a difference between one of the reference temperatures corresponding to the each of the N first filtering moments and one of the N comparison temperatures corresponding to the each of the N first filtering moments as one of the N temperature differences, and taking the N temperature differences as the filtered temperature data;

the determining of whether the battery meets the second alarm condition based on the filtered temperature data and the filtered status data comprises:

when each of the N temperature differences is greater than a preset temperature difference threshold and each of the filtered status data is preset status data, determining that the battery meets the second alarm condition.

5. The battery thermal runaway warning method according to claim 2, wherein the electrical performance data sequences comprise a temperature data sequence and a status data sequence respectively corresponding to the temperature data and the status data;

the performing of the filtering and detection processing on the electrical performance data sequences to obtain the filtered electrical performance data comprises:

obtaining the filtered status data by obtaining a segment of status data for a first preset duration from the status data sequence; and
obtaining the filtered temperature data by obtaining a segment of temperature data for a second preset duration from the temperature data sequence; and

the determining of whether the battery meets the second alarm condition based on the filtered temperature data and the filtered status data comprises:
when each temperature data of the filtered temperature data is greater than a preset temperature and each of the filtered status data is preset status data, determining that the battery meets the second alarm condition.

6. The battery thermal runaway warning method according to claim 2, wherein the electrical performance data sequences comprise a temperature data sequence and a status data sequence respectively corresponding to the temperature data and the status data;

the performing of the filtering and detection processing on the electrical performance data sequences to obtain the filtered electrical performance data comprises:

obtaining the filtered status data by obtaining a segment of status data for a first preset duration from the status data sequence;
obtaining a temperature rise rate sequence by calculating a temperature rise rate between every two adjacent temperature data of the temperature data sequence; and
obtaining the filtered temperature data by obtaining a part of the temperature rise rate sequence corresponding to a third preset time period; and

the determining of whether the battery meets the second alarm condition based on the filtered temperature data and the filtered status data comprises:
when each temperature rise rate of the filtered temperature data is greater than a preset rate and each of the filtered status data is preset status data, determining that the battery meets the second alarm condition.

7. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

selecting N temperature data respectively corresponding to N first filtering moments from the temperature data sequence as reference temperatures, wherein a time interval between every two adjacent ones of the N first filtering moments is uniform, and N is a natural number greater than 2;
obtaining N comparison temperatures by, for each of the reference temperatures, obtaining temperature data corresponding to a moment being P moments ahead of one of the N first filtering moments corresponding to the each of the reference temperatures from the temperature data sequence as one of the N comparison temperatures;
obtaining N temperature differences by, for each of the N first filtering moments, calculating a difference between one of the reference temperatures corresponding to the each of the N first filtering moments and one of the N comparison temperatures corresponding to the each of the N first filtering moment as one of the N temperature differences, and taking the N temperature differences as the filtered temperature data; and
obtaining the filtered voltage data by obtaining a segment of voltage data for a fourth preset duration from the voltage data sequence; and

the determining of whether the battery meets the first alarm condition based on the filtered voltage data and the filtered temperature data comprises:

when each of the N temperature differences is greater than a preset temperature difference threshold and each voltage data of the filtered voltage data is less than or equal to a preset voltage threshold, determining that the battery meets the first alarm condition.

8. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

obtaining a temperature rise rate sequence by calculating a temperature rise rate between every two adjacent temperature data of the temperature data sequence;
obtaining the filtered temperature data by obtaining a part of the temperature rise rate sequence corresponding to a third preset time period;
selecting M voltage data respectively corresponding to M second filtering moments from the voltage data sequence as reference voltages, wherein a time interval between every two adjacent ones of the M second filtering moments is uniform, and M is a natural number greater than 2;
obtaining M comparison voltages by, for each of the reference voltages, obtaining voltage data corresponding to a moment being Q moments ahead of one of the M second filtering moments corresponding to the each of the reference voltages from the voltage data sequence as one of the M comparison voltages; and
obtaining M voltage differences by, for each of the M second filtering moments, calculating a difference between one of the M comparison voltages corresponding to the each of the M second filtering moments and one of the reference voltages corresponding to the each of the M second filtering moments as one of the M voltage differences, and taking the M voltage differences as the filtered voltage data; and

the determining of whether the battery meets the first alarm condition based on the filtered voltage data and the filtered temperature data comprises:

when each temperature rise rate of the filtered temperature data is greater than a preset rate and each of the M voltage differences is greater than a preset voltage drop threshold, determining that the battery meets the first alarm condition.

9. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

obtaining a temperature rise rate sequence by calculating a temperature rise rate between every two adjacent temperature data of the temperature data sequence;
obtaining the filtered temperature data by obtaining a part of the temperature rise rate sequence corresponding to a third preset time period; and
obtaining the filtered voltage data by obtaining a segment of voltage data for a fourth preset duration from the voltage data sequence; and

the determining of whether the battery meets the first alarm condition based on the filtered voltage data and the filtered temperature data comprises:

when each temperature rise rate of the filtered temperature data is greater than a preset rate and each voltage data of the filtered voltage data is less than or equal to a preset voltage threshold, determining that the battery meets the first alarm condition.

10. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

obtaining the filtered temperature data by obtaining a segment of temperature data for a second preset duration from the temperature data sequence;

selecting M voltage data respectively corresponding to M second filtering moments from the voltage data sequence as reference voltages, wherein a time interval between every two adjacent ones of the M second filtering moments is uniform, and M is a natural number greater than 2;

obtaining M comparison voltages by, for each of the reference voltages, obtaining voltage data corresponding to a moment being Q moments ahead of one of the M second filtering moments corresponding to the each of the reference voltages from the voltage data sequence as one of the M comparison voltages; and

obtaining M voltage differences by, for each of the M second filtering moments, calculating a difference between one of the M comparison voltages corresponding to the each of the M second filtering moments and one of the reference voltages corresponding to the each of the M second filtering moments as one of the M voltage differences, and taking the M voltage differences as the filtered voltage data; and

the determining of whether the battery meets the first alarm condition based on the filtered voltage data and the filtered temperature data comprises:

when each temperature data of the filtered temperature data is greater than a preset temperature and each of the M voltage differences is greater than a preset voltage drop threshold, determining that the battery meets the first alarm condition.

11. The battery thermal runaway warning method according to claim 2, wherein the electrical performance data sequences comprise a temperature data sequence and a voltage data sequence respectively corresponding to the temperature data and the voltage data;

the performing of the filtering and detection processing on the electrical performance data sequences to obtain the filtered electrical performance data comprises:

obtaining the filtered voltage data by obtaining a segment of voltage data for a fourth preset duration from the voltage data sequence; and

obtaining the filtered temperature data by obtaining a segment of temperature data for a second preset duration from the temperature data sequence; and

the determining of whether the battery meets the first alarm condition based on the filtered voltage data and the filtered temperature data comprises:

when each temperature data of the filtered temperature data is greater than a preset temperature and each voltage data of the filtered voltage data is less than or equal to a preset voltage threshold, determining that the battery meets the first alarm condition.

12. A battery thermal runaway warning apparatus, comprising:

an obtaining module configured to obtain electrical performance data sequences comprising a plurality of respective sequences of a plurality of types of electrical performance data of a battery to be detected;

a filtering module configured to perform filtering and detection processing on the electrical performance data sequences to obtain filtered electrical performance data; and

a determination module configured to determine, based on the filtered electrical performance data, whether the battery meets a preset alarm condition, and output a warning signal when the battery meets the preset alarm condition.

13. An electronic device, comprising a memory and a processor, wherein an application program is stored in the memory, and the processor is configured to run the application program in the memory to perform steps of the battery thermal runaway warning method of any one of claims 1 to 11.

14. A computer-readable storage medium storing a computer program executable by a processor to perform steps of the battery thermal runaway warning method of any one of claims 1 to 11.

obtaining electrical performance data sequences comprising a plurality of respective sequences of a plurality of types of electrical performance data of a battery to be detected ⌐ 101

↓

performing filtering and detection processing on the electrical performance data sequences to obtain filtered electrical performance data ⌐ 102

↓

determining, based on the filtered electrical performance data, whether the battery meets a preset alarm condition, and outputting a warning signal when the battery meets the preset alarm condition ⌐ 103

FIG. 1

thermal runaway
↓

| -30.0s | -29.9s | ······ | -29.0s | | 0.0s | 0.1s | ······ | 1.0s |
|--------|--------|--------|--------|--|------|------|--------|------|
| 25℃ | 25℃ | 25℃ | 25℃ | | 33℃ | 34℃ | 35℃ | 35℃ |

report fault at 1.0s

FIG. 2

| 0.0s | 0.1s | ······ | 1.0s | | 5.0s | 5.1s | ······ | 6.0s |
|------|------|--------|------|--|------|------|--------|------|
| 4V | 4V | 4V | 4V | | 2.5V | 4V | 4V | 4V |

no fault reported

FIG. 3

obtaining module — 201

filtering module — 202

determination module — 203

battery thermal runaway warning device 200

FIG. 4

303

power supply — 301

302

processor

memory

Input unit

304

FIG. 5

**TRANSLATION**

### INTERNATIONAL SEARCH REPORT

International application No.

**PCT/CN2024/133385**

| A. | CLASSIFICATION OF SUBJECT MATTER |
|---|---|

H01M10/42(2006.01)i; G01R31/36(2020.01)i

According to International Patent Classification (IPC) or to both national classification and IPC

| B. | FIELDS SEARCHED |
|---|---|

Minimum documentation searched (classification system followed by classification symbols)

IPC: H01M、G01R

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 电池, 电芯, 电压, 温度, 数据, 序列, 预警, 滤波, batter+, cell?, core?, voltage, temperature, data, series, warn+, filer+

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 115986244 A (CHINA NATIONAL INSTITUTE OF STANDARDIZATION et al.) 18 April 2023 (2023-04-18) description, paragraphs 30-81, and figures 1-8 | 1-14 |
| X | CN 117577983 A (SHENZHEN XINXIN INTELLIGENT CO., LTD.) 20 February 2024 (2024-02-20) description, paragraphs 8-43, and figure 1 | 1-14 |
| X | CN 118315704 A (CHINA AVIATION LITHIUM BATTERY CO., LTD.) 09 July 2024 (2024-07-09) description, paragraphs 54-181, and figures 1-6 | 1-14 |
| X | CN 118549818 A (WUHAN NARI LIMITED LIABILITY COMPANY OF STATE GRID ELECTRIC POWER RESEARCH INSTITUTE) 27 August 2024 (2024-08-27) description, paragraphs 26-187, and figures 1-5 | 1-14 |
| A | CN 117691224 A (EVE ENERGY CO., LTD.) 12 March 2024 (2024-03-12) entire document | 1-14 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **27 May 2025** | **30 May 2025** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**TRANSLATION**

**INTERNATIONAL SEARCH REPORT**
**Information on patent family members**

International application No.

**PCT/CN2024/133385**

| Patent document cited in search report | | | Publication date (day/month/year) | Patent family member(s) | Publication date (day/month/year) |
|---|---|---|---|---|---|
| CN | 115986244 | A | 18 April 2023 | None | |
| CN | 117577983 | A | 20 February 2024 | None | |
| CN | 118315704 | A | 09 July 2024 | None | |
| CN | 118549818 | A | 27 August 2024 | None | |
| CN | 117691224 | A | 12 March 2024 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411248353